# EUROPEAN PATENT APPLICATION

(11) **EP 2 360 013 A1**
(43) Date of publication of application: **24.08.2011**
(21) Application number: 09828813.7
(22) Date of filing: 20.11.2009
(51) Int. Cl.: B32B 27/28, G06K 19/077, H05K 3/28

(54) **PROTECTIVE FILM FOR ELECTRONIC COMPONENT, MANUFACTURING METHOD THEREFOR, AND USE THEREOF**

(30) Priority: 27.11.2008 JP 2008302118
(71) Applicant: Du Pont-Mitsui Polychemicals Co., Ltd., Tokyo 105-7117 (JP)
(72) Inventor: MAKI, Nobuyuki, Tokyo 105-7117 (JP); HASHIMOTO, Hidenori, Ichihara-shi Chiba 299-0108 (JP)
(74) Representative: Gulde Hengelhaupt Ziebig & Schneider
(86) International application number: PCT/JP2009/006265
(87) International publication number: WO 2010/061563

(57) **Abstract**

Disclosed is a protective film for an electronic component comprising a base material containing a heat resistant resin and an adhesive layer formed on the base material containing an ethylene-unsaturated carboxylic acid copolymer or a metal salt thereof, wherein the ethylene-unsaturated carboxylic acid copolymer or the metal salt thereof contains 3 to 30% by weight of the structural unit derived from an unsaturated carboxylic acid.

## Description

### TECHNICAL FIELD

The present invention relates to a protective film for an electronic component, a method for manufacturing the protective film, and use thereof.

### BACKGROUND ART

Conventional protective films have been disclosed, for example, in Patent Documents 1 and 2. In these documents, there is disclosed a protective film comprising a thermosetting adhesive layer having a copolymer of ethylene and acrylate and/or methacrylate monomer and maleic acid and/or maleic anhydride as a major component on at least one surface of an organic film having heat resistance.
Patent Document 3 discloses a laminated film obtained by extrusion laminating a mixed resin composition containing an ethylene-unsaturated carboxylic acid copolymer onto at least one surface of a polyester film. According to the document, the film can be used as a packaging material for food or the like.

### PRIOR ART REFERENCES

### PATENT DOCUMENTS

Patent Document 1: Japanese Patent Application Laid-Open No. 1997-207283
Patent Document 2: Japanese Patent Application Laid-Open No. 2002-69414
Patent Document 3: Japanese Patent Application Laid-Open No. 2001-54938

### DISCLOSURE OF THE INVENTION

However, since the protective film in Patent Documents 1 and 2 has a thermosetting adhesive layer, other components such as a curing agent, organic peroxide are required, in addition to a main agent exhibiting adhesion. Thus, there has been a tendency to require attention to handling and it has not been appropriate for storage for a long period of time. An object of the invention according to Patent Document 3 is mainly to provide a film for the use of a packaging material, and the field of the invention is totally different from the protective film for an electronic component of the present invention.

Besides, the adhesive layer in Patent Document 1 and 2 is thermosetting and is formed by a coating method, so that complicated steps such as a step of applying an adhesive solution, a curing step for half-curing, and a step of laminating a mold release film to the half-cured adhesive (batch production for each independent step) are required, the time involved in manufacturing a piece of protective film is relatively long, and the productivity including facilities needs to be improved. Furthermore, the working environment also needs to be improved in order to use an organic solvent for the application of a conventional adhesive. Furthermore, for example, a curing step has been required for several tens of minutes for adhesion and curing even after lamination of the film to a flexible printed circuit board (FPC).

The present invention can be specified by the following matters.
(1) A protective film for an electronic component, comprising a base material containing a heat resistant resin, and an adhesive layer formed on said base material and containing an ethylene-unsaturated carboxylic acid copolymer or a metal salt thereof, wherein the ethylene-unsaturated carboxylic acid copolymer or the metal salt thereof contains 3 to 30% by weight of the structural unit derived from an unsaturated carboxylic acid.

(2) The protective film for an electronic component as set forth in (1), wherein, in the ethylene-unsaturated carboxylic acid copolymer or the metal salt thereof, the ethylene-unsaturated carboxylic acid copolymer is an ethylene-(meth)acrylic acid copolymer.

(3) The protective film for an electronic component as set forth in (1) or (2), wherein, in the ethylene-unsaturated carboxylic acid copolymer or the metal salt thereof, a metal cation constituting the metal salt is one or more kinds selected from the group consisting of Na⁺, K+ Li⁺, Ca²⁺ Mg²⁺ Zn²⁺ Cu²⁺, Co²⁺ Ni²⁺ Mn²⁺ and Al³⁺.

(4) The protective film for an electronic component as set forth in any one of (1) to (3), wherein said adhesive layer is obtained by extrusion molding the ethylene-unsaturated carboxylic acid copolymer or the metal salt thereof from a T die.

(5) The protective film for an electronic component as set forth in any one of (1) to (4), wherein MFR of the ethylene-unsaturated carboxylic acid copolymer or the metal salt thereof is 0.1 to 100 g/10 minutes.

(6) The protective film for an electronic component as set forth in any one of (1) to (5), wherein a layer containing an anchor coating agent is provided between said base material and said adhesive layer.

(7) The protective film for an electronic component as set forth in any one of (1) to (6), obtained by extruding the heated ethylene-unsaturated carboxylic acid copolymer or the metal salt thereof from a T die to give a film, and laminating the film on said base material.

(8) A method for manufacturing a protective film for an electronic component, comprising:
heating the ethylene-unsaturated carboxylic acid copolymer or the metal salt thereof containing 3 to 30% by weight of the structural unit derived from an unsaturated carboxylic acid, and
forming an adhesive layer containing the ethylene-unsaturated carboxylic acid copolymer or the metal salt thereof on said base material to which a film formed by extruding the melted ethylene-unsaturated carboxylic acid copolymer or the metal salt thereof from a T die is laminated.

(9) The method for manufacturing a protective film for an electronic component as set forth in (8), further comprising:
applying an anchor coating agent on a surface of said base material to place said anchor coating agent in between said base material and said adhesive layer, before said the step of forming said adhesive layer.

(10) The method for manufacturing a protective film for an electronic component as set forth in (8) or (9), in which MFR of the ethylene-unsaturated carboxylic acid copolymer or the metal salt thereof is 0.1 to 100 g/10 minutes.

(11) A circuit board obtained by bonding the protective film for an electronic component as set forth in any one of (1) to (7) thereto.

(12) The circuit board as set forth in (11), wherein the circuit board is a flexible printed circuit board.

(13) A semiconductor device comprising:
a substrate,
a semiconductor element mounted on said substrate and
the protective film for an electronic component as set forth in any one of (1) to (7) bonded to the surface of said semiconductor element.

(14) An IC tag comprising:
a base material having an antenna,
an IC chip mounted on said base material and
the protective film for an electronic component as set forth in any one of (1) to (7) bonded to the surfaces of said antenna and said IC chip.

The protective film for an electronic component of the present invention is excellent in adhesiveness to a metal constituting the electronic component, and is also excellent in chemical resistance because corrosion to chemicals used for forming a circuit by etching is further suppressed. For example, in the production of a multi-layer flexible printed circuit board by building up, etching can be carried out while this protective film for an electronic component is laminated, and this protective film for an electronic component functions as an insulating layer in the completed multi-layer flexible printed circuit board. In this way, it is possible to enhance the reliability of a product to which the protective film for an electronic component of the present invention is bonded. The ethylene-unsaturated carboxylic acid copolymer or the metal salt thereof contained in the adhesive layer can be formed by extruding from the T die, and the protective film for an electronic component of the present invention serving as a thermoplastic adhesive layer is configured to have excellent productivity. According to the method for manufacturing a protective film for an electronic component of the present invention, the ethylene-unsaturated carboxylic acid copolymer or the metal salt thereof is extruded from a T die to form an adhesive layer, and the protective film can be simply manufactured without employing complicated steps as compared to the thermosetting adhesive. Thus, simplified steps are achieved, the productivity is excellent since the time involved in manufacturing is shortened, and consideration for the working environment by use of an organic solvent is reduced.

### BRIEF DESCRIPTION OF THE DRAWINGS

Fig. 1 is a cross-sectional view schematically illustrating a protective film for an electronic component according to the embodiment.
Fig. 2 (a) is a schematic top perspective view of an IC tag according to the embodiment, while Fig. 2 (b) is an A-A line cross-sectional view of Fig. 2 (a).
Fig. 3 is a graph illustrating adhesive strength of an adhesive layer to a copper foil in Examples.
Fig. 4 is a graph illustrating adhesive strength of an adhesive layer to a copper foil in Examples.

### BEST MODE FOR CARRYING OUT THE INVENTION

The embodiments of the present invention will be described in conjunction with the drawings below. Incidentally, in all drawings, the same components are assigned the same reference numerals and appropriate explanations thereof will be omitted.

### Protective Film for Electronic Component

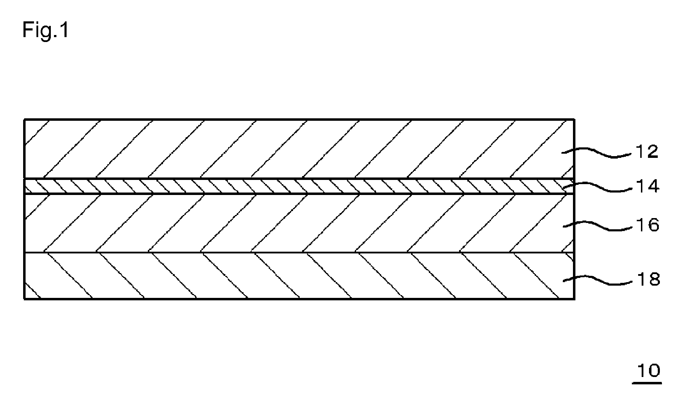

As shown in Fig. 1, a protective film for an electronic component 10 of present embodiment is obtained by laminating a base material 12, a layer containing an anchor coating agent (hereinafter referred to as an anchor coating layer 14), an adhesive layer 16 and a mold release film 18 in order. As the mold release film 18, paper, a PET film or the like may be used.

The base material 12 may contain a heat resistant resin such as a poly-p-phenylene terephthalamide (PPTA), a polyethylene terephthalate (PET), a polyethylene naphthalate (PEN), a polyimide, a polyphenylene sulfide, a polyetheretherketone (PEEK), various liquid crystalline polymers (LCPs), a polyolefin.
In present embodiment, it is preferable to contain a polyimide resin or PET from the viewpoint of improvement in proper heat resistance. A thickness of the base material 12 is about 2 to 100 µm and preferably about 2 to 50 µm.

The adhesive layer 16 according to present embodiment contains an ethylene-unsaturated carboxylic acid copolymer or a metal salt thereof. Adhesion to a metal film is improved by the adhesive layer 16 containing such a resin, whereby product reliability is enhanced. In particular, as the amount of the carboxylic acid becomes high, adhesion to a metal film is further enhanced. A thickness of the adhesive layer 16 is about 5 to 30 µm.

The ethylene-unsaturated carboxylic acid copolymer or the metal salt thereof contains 3 to 30% by weight, preferably 4 to 20% by weight, further preferably 7 to 20% by weight, and particularly preferably 10 to 20% by weight of the structural unit derived from an unsaturated carboxylic acid. Thus, adhesion between the adhesive layer 16 of the protective film for an electronic component and the metal constituting the electronic component, and molding processability of the protective film for an electronic component are well balanced. Furthermore, corrosion to chemicals used for forming a circuit by etching is suppressed and chemical resistance is also excellent. Incidentally, from the viewpoint of improvement in adhesion between the adhesive layer 16 and the metal, the unsaturated carboxylic acid copolymer can be separately added in the ranges in which molding processability is not affected.

The ethylene-unsaturated carboxylic acid copolymer used in present embodiment is a copolymer of ethylene and unsaturated carboxylic acid. As the unsaturated carboxylic acid, there are used an unsaturated carboxylic acid having 3 to 8 carbon atoms, specifically, acrylic acid, methacrylic acid, itaconic acid, maleic anhydride, maleic acid monomethyl ester, maleic acid monoethyl ester and the like. Of these unsaturated carboxylic acids, particularly preferably used are acrylic acid and methacrylic acid from the viewpoint of the above effects.

Meanwhile, the ethylene-unsaturated carboxylic acid copolymer may be a multi-component copolymer consisting of three or more components. In addition to the above components which are copolymerizable with ethylene, there may be copolymerized with an unsaturated carboxylic acid ester such as methyl acrylate, ethyl acrylate, isobutyl acrylate, n- butyl acrylate, isooctyl acrylate, methyl methacrylate, isobutyl methacrylate, dimethyl maleate, diethyl maleate; vinyl esters such as vinyl acetate, vinyl propionate; unsaturated hydrocarbons such as propylene, butene, 1,3-butadiene, pentene, 1,3-pentadiene, 1-hexene; oxides such as vinyl sulfate, vinyl nitrate; halogen compounds such as vinyl chloride, vinyl fluoride; vinyl group-containing primary and secondary amine compounds; carbon monoxide, sulfur dioxide; and the like as a third component.

The metal salt of the ethylene-unsaturated carboxylic acid copolymer (ionomer) used in present embodiment is obtained by crosslinking at least a part of the carboxyl group in the aforementioned ethylene-unsaturated carboxylic acid copolymer with the metal cation.

Examples of the metal cation for crosslinking the ethylene-unsaturated carboxylic acid copolymer include monovalent-trivalent cations such as Na⁺, K⁺, Li⁺, Ca²⁺, Mg²⁺, Zn²⁺, Cu²⁺, Co²⁺, Ni^{2+,} Mn²⁺, Al³⁺. These may be used singly or in combination of two or more kinds.

A proper ionomer is an ionomer in which 10 to 90% of the carboxylic acid derived from an unsaturated carboxylic acid is neutralized with a cation, comprising a copolymer of ethylene and unsaturated carboxylic acid synthesized by the high-pressure radical polymerization method serving as a base.

Furthermore, the melting point of the ethylene-unsaturated carboxylic acid copolymer or the metal salt thereof is generally about 70 to 110°C. In consideration of molding processability or the like, the melt flow rate (MFR, JIS K7210-1999 (hereinafter 190°C, a load of 2, 160 g)) of the ethylene-unsaturated carboxylic acid copolymer or the metal salt thereof may be 0.1 to 100 g/10 minutes and preferably 1 to 50 g/10 minutes.

Furthermore, the adhesive layer 16 may contain, in addition to the ethylene-unsaturated carboxylic acid copolymer or the metal salt thereof, an additive such as an anti-oxidant, a stabilizer, a lubricant, an adhesive, a coloring agent.

The anchor coating agent used in the embodiment may be selected from anchor coating agents such as a titanium anchor coating agent such as alkyl titanate or the like, a polyurethane anchor coating agent, a polyester anchor coating agent, a polyethyleneimine anchor coating agent, a polyisocyanate anchor coating agent. The anchor coating agents are not restricted thereto, and may be properly selected according to the use. The anchor coating agent may be one-component solvent type, two-component solvent type or three-component solvent type, and in addition thereto, may be solvent-free aqueous type.

The anchor coating agent may be properly selected from commercial products. Furthermore, it may be selected according to the object of the present invention from commercial products as a coating agent. Examples of the commercial product include TITA BOND (product name, manufactured by Nippon Soda Co., Ltd., T-19, T-120, etc.), ORGATIX (product name, sold by Matsumoto Trading Co., Ltd., PC-105, etc.), TAKELAC/TAKENATE (product name, manufactured by Mitsui Chemicals Polyurethanes, Inc., A-3200/A-3003, A-968/A-8, etc.), SEIKA BOND (product name, manufactured by Dainichiseika Color & Chemicals Mfg. Co., Ltd., A-141/C-137, E-263/C-26, etc.), SEIKADYNE (product name, manufactured by Dainichiseika Color & Chemicals Mfg. Co., Ltd., 2710A/2710B, 2730A/2730B/DEW I, 2710A/2810C/DEW I, etc.), BONDEIP (manufactured by Active Business Studio, PA100, PM), LX-415, etc. (product name, manufactured by DIC Corporation) and the like.

Furthermore, some of the aforementioned commercial anchor coating agents are commercial products used as an adhesive imparted with antistatic properties (for example, BONDEIP PA100) which may be used.

In present embodiment, the base material having the anchor coating layer 14 can be obtained by coating the base material with the anchor coating agent in an in-line or off-line manner. A thickness of the anchor coating layer 14 is usually about 0.01 to 5 µm and particularly preferably about 0.01 to 0.5 µm.
Furthermore, the surface of the base material before the formation of the anchor coating layer 14 or the surface of the anchor coating layer 14 may be subjected to an ozone treatment, a plasma treatment, a corona discharge treatment, a flame treatment or the like.

### Method for Manufacturing Protective Film for Electronic Component

The protective film for an electronic component 10 of present embodiment can be manufactured according to an extrusion lamination method from a T die, or a dry lamination method such as a thermal lamination method, a heat sealing method, a heat press method.

In present embodiment, since the melting point and the melt flow rate of the ethylene-unsaturated carboxylic acid copolymer or the metal salt thereof are within the above range, the protective film can be manufactured continuously by the extrusion lamination method from the T die, and the productivity of the protective film for an electronic component is highly improved.
For example, the ethylene-unsaturated carboxylic acid copolymer or the metal salt thereof is extrusion laminated from the T die, and bonded onto a film base material to be fed from a polyimide film, a polyester film or a polyolefin film which has been wound into a roll, and thereafter the mold release film to be fed from the rolled state is laminated thereto, thus enabling continuous lamination with a pressure bonding roller. Therefore, the protective film for an electronic component can be continuously manufactured without requiring complicated steps.

In present embodiment, the protective film for an electronic component 10 can be manufactured in the following manner.
First, in an extrusion laminating equipment, the ethylene-unsaturated carboxylic acid copolymer or the metal salt thereof is heated at a predetermined temperature so as to melt the same, resulting in improving the fluidity of the resin. Then, the melted resin is extruded from the T die and formed into a film shape.

The extrusion temperature during the extrusion laminating process is different depending on the kind of the resin, but it is preferably in the range of 250 to 350°C and particularly preferably in the range of 280 to 330°C as a resin temperature measured directly under the T die.
The extrusion molded film is fed to a laminating section equipped with a pair of rolls.

On the other hand, when the film is formed by extrusion, at the same time the surface on which the adhesive layer 16 of the base material 12 is planned to be formed is coated with an anchor coating agent to form the anchor coating layer 14. Adhesiveness between the base material 12 and the adhesive layer 16 is further improved by use of the anchor coating layer 14.

Specifically, the anchor coating agent is applied to the base material 12 using a coating apparatus attached to the extrusion laminating equipment, and the base material in which a diluting solvent used for the anchor coating agent is dried with a dryer is fed to the laminating section at a fixed speed. The mold release film 18 is also fed to the laminating section.

Then, the extrusion molded film fed between the pair of rolls of the laminating section, the base material 12 having the anchor coating layer 14 and the mold release film 18 are supplied between the rolls and pressed, so that a protective film for an electronic component obtained by laminating the base material 12, the anchor coating layer 14, the adhesive layer 16 and the mold release film 18 in order is manufactured.

According to the method for manufacturing a protective film for an electronic component of the present invention, the ethylene-unsaturated carboxylic acid copolymer or the metal salt thereof is extruded from the T die to form the adhesive layer and the productivity is excellent.

### Use

The adhesive layer of the protective film for an electronic component of present embodiment is excellent in adhesion to a metal, particularly to copper. For this reason, the protective film for an electronic component of present embodiment comes to have excellent adhesiveness to metal members such as wirings, electrodes, wires and leads constituting the electronic component, and can be used as a surface protective film to be bonded to the surface of the electronic component, electronic circuit. Specifically, it can be used as a surface protective film (a coverlay film) of a circuit board, a surface protective film of an IC tag, a surface protective film of a semiconductor device and the like.

In present embodiment, the adhesive layer 16 contains the ethylene-unsaturated carboxylic acid copolymer or the metal salt thereof having the structural unit derived from an unsaturated carboxylic acid in a predetermined amount, whereby adhesion between the adhesive layer 16 and the metal, particularly copper, is excellent, and product reliability of circuit boards, IC tags, semiconductor devices and the like is enhanced.

Examples of the circuit board include flexible printed circuit boards, rigid substrates composed of glass epoxy, ceramic, a metal core substrate or the like, optical circuits or optical-electric mixed circuit boards formed on glass or polymer, TAB tapes and the like. Examples of the flexible printed circuit board include one-sided, both-sided or multi-layer flexible printed circuit boards.

The protective film for an electronic component of present embodiment can protect the circuit board by laminating the adhesive layer 16 surface revealed by peeling off the mold release film 18 for use and a metal foil or a wiring layer for press bonding and curing them. Even when the protective film for an electronic component of present embodiment is used as a coverlay film of the circuit board, the adhesive layer 16 has adhesiveness or the like to such a level that adhesiveness causes no troubles in practice.

Furthermore, the protective film for an electronic component of present embodiment can protect semiconductor elements, and wirings, wires, leads and the like, which are composed of metals such as copper, by covering a semiconductor element, an insulating film above the semiconductor element or the like in the semiconductor device comprising a substrate and a semiconductor element mounted on the substrate. Examples of the semiconductor device include SOC, SIP, COF tapes and the like.

The protective film for an electronic component of present embodiment can be used as a protective film for an IC tag.

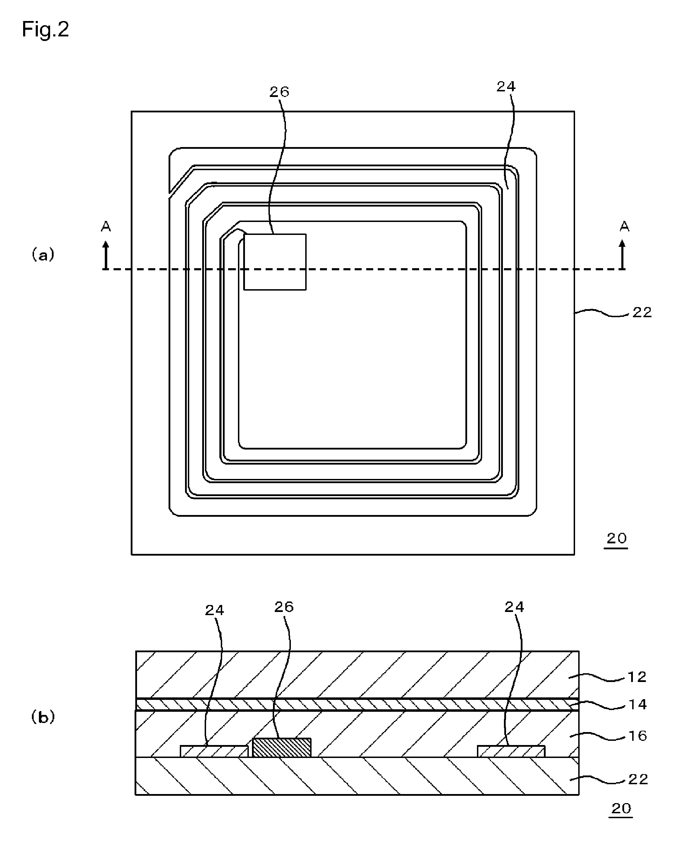

Fig. 2 (a) is a schematic top perspective view of an IC tag according to present embodiment. Also, Fig. 2 (a) illustrates an antenna and an IC chip on the base material without illustrating the protective film for an electronic component. Fig. 2 (b) is an A-A line cross-sectional view of Fig. 2 (a).
As shown in Figs. 2 (a) and (b), an IC tag 20 is provided with an antenna 24 composed of a metal such as copper on a base material (a base material film 22) serving as a base and an IC chip 26 mounted on the base material film 22. The antenna 24 and the IC chip 26 are electrically connected. Furthermore, the protective film for an electronic component for protecting the antenna 24 and the IC chip 26 is laminated through the adhesive layer 16.
As the base material film 22, the protective film for an electronic component of present embodiment may be used.

### EXAMPLES

The present invention is now illustrated in detail below. However, the present invention is not restricted to these Examples.

(1) Configuration of Protective Film for Electronic Component The following number in the parenthesis () denotes a thickness (µm) of a layer, and AC refers to an anchor coating agent (thickness of AC layer: 0.2 µm).
- Protective film for an electronic component (a): Polyimide base material (25)/AC layer/adhesive layer (30)
- Protective film for an electronic component (b): PET base material (100)/AC layer/adhesive layer (20)

(2) Manufacture of Protective Film for Electronic Component
Device: A product of Sumitomo Heavy Industries Modern, Ltd.
Extruder: 65 mmϕ, L/D=28
Screw: 3-stage type, CR=4.78
Die: 900 mm wide, inner Deckel type
Resin temperature: 250°C for adhesive (f), 300°C for other adhesives
Line speed: 120 m/minute

The protective film was manufactured according to a method comprising extrusion laminating a base material coated with an anchor coating (AC) agent and an extrusion molded film under the above conditions.

### Raw Material

- Polyimide base material: Polyimide film (product name: KAPTON, manufactured by Toray Industries, Inc., 100-m wound)
- PET base material: PET film (product name: LUMIRROR, manufactured by Toray Industries, Inc.)

### • AC agent

AC agent (a): SEIKADYNE 2710A: 1 part by weight, SEIKADYNE 2710C: 2 parts by weight (Dainichiseika Color & Chemicals Mfg. Co., Ltd.)
AC agent (b): SEIKADYNE 2710A: 1 part by weight, SEIKADYNE 2810C(T): 4 parts by weight, DEW I: 0.25 parts by weight (Dainichiseika Color & Chemicals Mfg. Co., Ltd.)

### • Adhesive

Adhesive (a): Ethylene-methacrylic acid copolymer, content of the structural unit derived from a methacrylic acid: 4% by weight, MFR: 7 g/10 minutes

Adhesive (b): Ethylene-acrylic acid copolymer, content of the structural unit derived from an acrylic acid: 12% by weight, MFR: 10 g/10 minutes

Adhesive (c): Ethylene-methacrylic acid copolymer, content of the structural unit derived from a methacrylic acid: 11% by weight, MFR: 8 g/10 minutes

Adhesive (d) : Zn salt of an ethylene-methacrylic acid copolymer, content of the structural unit derived from a methacrylic acid in the ethylene-methacrylic acid copolymer: 9% by weight, degree of neutralization with Zn: 17%, MFR: 5.5 g/10 minutes

Adhesive (e) : Zn salt of an ethylene-methacrylic acid copolymer, content of the structural unit derived from a methacrylic acid in the ethylene-methacrylic acid copolymer: 15% by weight, degree of neutralization with Zn: 23%, MFR: 5 g/10 minutes

Adhesive (f): Addition of an additive (ARKON (manufactured by Arakawa Chemical Industries, Ltd.)) to an ethylene-methacrylic acid copolymer, content of the structural unit derived from a methacrylic acid in the ethylene-methacrylic acid copolymer: 10% by weight, MFR: 32 g/10 minutes

Adhesive (g): Ethylene-methacrylic acid copolymer, content of the structural unit derived from a methacrylic acid: 2% by weight, MFR: 7.5 g/10 minutes

Adhesive (h): Low density polyethylene, MFR: 7.2 g/10 minutes

### Method for Measuring Physical Properties

### • Melt flow rate (MFR)

In accordance with JIS K 7210-1999, it was measured at a temperature of 190°C with a load of 2,160 g.

### • Adhesive Strength of Adhesive Layer to Polyimide Film

A protective film for an electronic component was allowed to stand at 40°C for 2 days, and then adhesive strength of the adhesive layer to the polyimide film was confirmed under the following conditions.
Peeling angle: 180° Peeling
Peeling conditions: 300 mm/min, 25 mm wide

### • Adhesive Strength of Adhesive Layer to Copper Foil

The adhesive layer of the protective film for an electronic component (a) prepared in Example was in contact with the copper foil of the following copper foil-attached base material (a) or (b), which were then laminated by carrying out heat sealing under the conditions of 0.2 MPa, a seal temperature of 160°C and a period of 0.5 seconds. In Examples 1 to 4, heat sealing was also carried out at a seal temperature each of 120°C, 140°C and 180°C. Then, adhesive strength between the adhesive layer and the copper foil was confirmed under the following conditions.

Copper foil-attached base material (a): Electrolytic copper foil
Examples 1 to 5: Polyimide (100)/AC layer/adhesive layer (15) /electrolytic copper foil (10)
Examples 6 to 15: PET (100)/AC layer/adhesive layer (15) /electrolytic copper foil (10)

Copper foil-attached base material (b): Surface of rolled copper foil is treated with Cr
Examples 1 to 5: Polyimide (100)/AC layer/adhesive layer (15) /copper foil treated with Cr (10)
Examples 6 to 15: PET (100) /AC layer/adhesive layer (15) /copper foil treated with Cr (10)

Peeling angle: 180° Peeling
Peeling conditions: 300 mm/min, 25 mm wide

### Examples 1 to 5

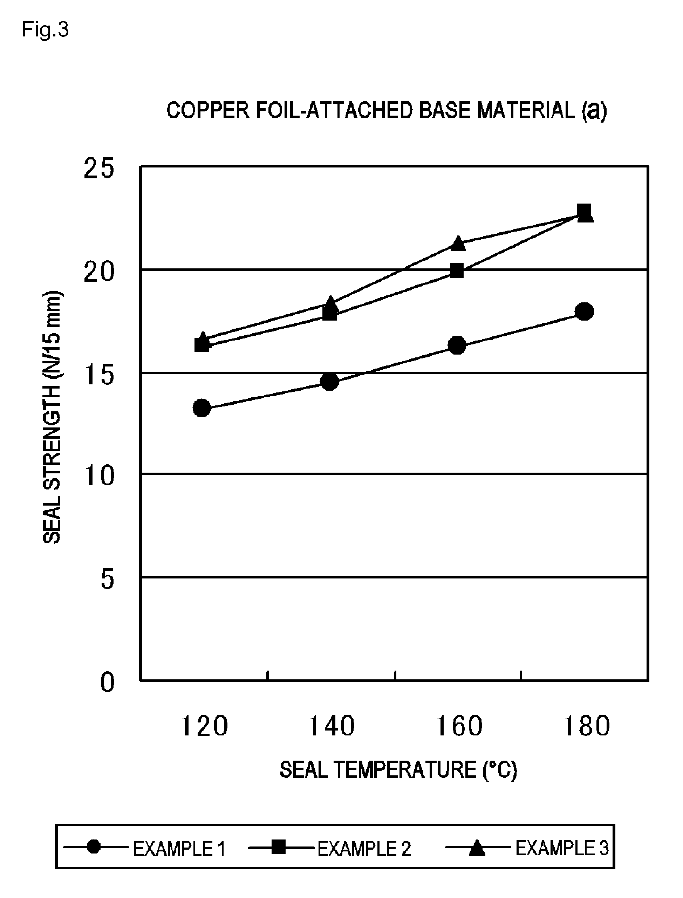

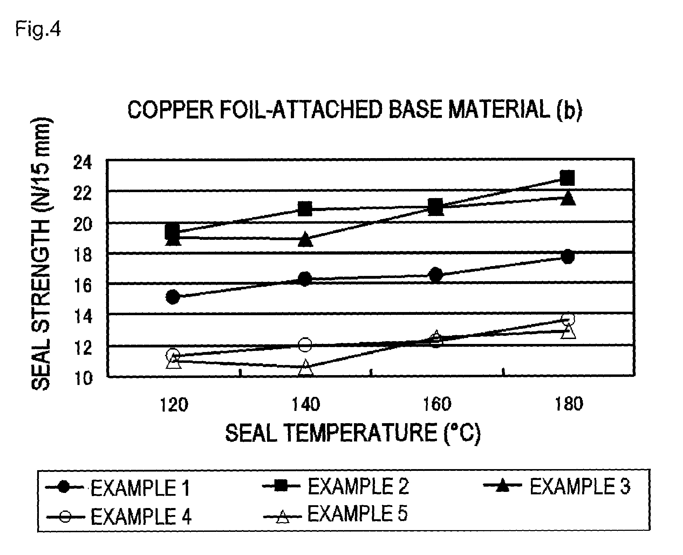

For a configuration of the protective film for an electronic component (a), protective films for an electronic component were manufactured using those in Tables 1 and 2 as an adhesive layer and as an AC agent to give Examples 1 to 5 in order. Incidentally, in Examples 1 to 5, before the formation of the adhesive layer on the anchor coating layer, the anchor coating layer surface was subjected to an ozone treatment (O₃ concentration: 25 g/m³, processing amount: 1 m³/h).
Adhesive strength of the adhesive layer to the polyimide film is shown in Table 1, while adhesive strength of the adhesive layer to the copper foil is shown in Table 2. The results shown in Table 2 are illustrated in Figs. 3 and 4.

**[Table 1]**

| Adhesive strength of adhesive layer to polyimide film | | | |
|---|---|---|---|
| | | | Adhesive Strength (N/15 mm) |
| | Adhesive Layer | AC Agent | 40°C x 2 days after |
| Example 1 | (a) | (b) | 3.4 |
| Example 2 | (b) | (a) | 5.3 |
| Example 3 | (b) | (b) | 3.6 |
| Example 4 | (g) | (b) | 4.4 |
| Example 5 | (h) | (b) | 3.7 |

**[Table 2]**

| Adhesive strength of adhesive layer to copper foil | | | | | | | | | | |
|---|---|---|---|---|---|---|---|---|---|---|
| | | | Copper Foil-Attached Base Material (a) (N/15 mm) | | | | Copper Foil-Attached Base Material (b) (N/15 mm) | | | |
| | Adhesive Layer | AC Agent | 120°C | 140°C | 160°C | 180°C | 120°C | 140°C | 160°C | 180°C |
| Example 1 | (a) | (b) | 13.2 | 14.5 | 16.2 | 17.9 | 15.1 | 16.3 | 16.5 | 17.7 |
| Example 2 | (b) | (a) | 16.2 | 17.7 | 19.9 | 22.8 | 19.3 | 20.8 | 21.0 | 22.8 |
| Example 3 | (b) | (b) | 16.6 | 18.3 | 21.3 | 22.7 | 19.0 | 18.9 | 20.9 | 21.5 |
| Example 4 | (g) | (b) | - | - | - | - | 11.3 | 12.0 | 12.2 | 13.6 |
| Example 5 | (h) | (b) | - | - | - | - | 11.0 | 10.6 | 12.5 | 12.9 |

From the results of Table 1, it was confirmed that the protective film for an electronic component of the present invention was excellent in adhesion to the polyimide film. Meanwhile, from the results of Table 2, it was confirmed that the adhesive layer containing the ethylene-unsaturated carboxylic acid copolymer or the metal salt thereof was excellent in adhesion to the copper foil by use of this copolymer or the metal salt thereof containing not less than 3% by weight of the structural unit derived from an unsaturated carboxylic acid. Incidentally, as shown in Table 2, and Figs. 3 and 4, it was found that adhesion of the adhesive layer to the copper foil tended to be improved when the content of the structural unit derived from an unsaturated carboxylic acid contained in the adhesive layer was increased.

### Examples 6 to 15

For a configuration of the protective film for an electronic component (b), protective films for an electronic component were manufactured using those in Table 3 as an adhesive and using an AC agent (a) as an AC agent to give Examples 6 to 15 in order.
Adhesive strength of the adhesive layer to the copper foil is shown in Table 3.

**[Table 3]**

| Adhesive strength of adhesive layer to copper foil | | | |
|---|---|---|---|
| | Adhesive Layer | Copper Foil-attached Base Material (a) (N/15 mm) | Copper Foil-attached Base Material (b) (N/15 mm) |
| Example 6 | m-PE | 22.4 | 19.3 |
| Example 7 | EMA | 9.7 | 7.7 |
| Example 8 | EBA | 13.1 | 10.9 |
| Example 9 | EMMA | 2.4 | 2.3 |
| Example 10 | EVA | 1.3 | 1.3 |
| Example 11 | EEA | 15.3 | 11.9 |
| Example 12 | Adhesive (c) | 40.0 | 37.2 |
| Example 13 | Adhesive (d) | 35.9 | 28.7 |
| Example 14 | Adhesive (e) | 40.0 | 29.7 |
| Example 15 | Adhesive (f) | 38.8 | 37.6 |

| | | | |
|---|---|---|---|
| m-PE: Metallocene polyethylene, MFR: 8.0 g/10 minutes, density: 913 kg/m³) EMA: Ethylene-methyl acrylate copolymer EBA: Ethylene-butyl acrylate copolymer EMMA: Ethylene-methyl methacrylate copolymer EVA: Ethylene-vinyl acetate copolymer EEA: Ethylene-ethyl acrylate copolymer | | | |

### Examples 16 to 30

### Test of Chemical Resistance

The adhesive layer of the protective film for an electronic component (a) prepared in Example 2, and the electrolytic copper foil onto which a circuit pattern for testing formed on the surface of a flexible printed circuit board (FPC) was transferred were laminated so as to be in contact with each other, and then integrated into one body by heat pressing under the following conditions using a heat pressing machine (Model: MS-HP2) manufactured by Meisei Electric Co., Ltd.
Press temperature: 120°C
Press period: 10 seconds
Press pressure: 2 kg/cm²
Respective 5 laminates of the obtained protective film for an electronic component (a) and FPC were immersed in chemicals for 5 minutes each in accordance with JIS C5016-10.5, and then the presence or absence of the abnormality was confirmed by visual observation. For the chemicals, hydrochloric acid (2 mol/l) as the acid, an aqueous sodium hydroxide solution (2 mol/l) as the alkali and 2-propanol as the alcohol were used. The results are shown in Table 4.

**[Table 4]**

| | Kind of Chemicals | Results |
|---|---|---|
| Example 16 | Hydrochloric acid | No abnormality |
| Example 17 | | No abnormality |
| Example 18 | | No abnormality |
| Example 19 | | No abnormality |
| Example 20 | | No abnormality |
| Example 21 | Sodium hydroxide | No abnormality |
| Example 22 | | No abnormality |
| Example 23 | | No abnormality |
| Example 24 | | No abnormality |
| Example 25 | | No abnormality |
| Example 26 | 2-propanol | No abnormality |
| Example 27 | | No abnormality |
| Example 28 | | No abnormality |
| Example 29 | | No abnormality |
| Example 30 | | No abnormality |

### Examples 31 to 34

### Evaluation of amount of bleeding adhesive in coverlay

In the same manner as in Example 16, a laminate obtained by integrating FPC and the protective film for an electronic component (a) into one body was manufactured. Using this laminate, the maximum length of the adhesive bled at inner edges of concentric holes having various diameters arranged on the circuit pattern for testing of FPC was measured using a digital microscope, VH-6300, manufactured by Keyence Corporation by the test method in accordance with the standard of JPCA (Japan electronics Packaging and Circuits Association) BM-02. Incidentally, 16 points for holes having one diameter were measured to obtain an average, and this average was taken as the bleeding amount for holes having respective diameters. The allowance value for the coverlay was generally preferably not more than 300 µm. The results are shown in Table 5.

**[Table 5]**

| | Hole Diameter (mm) | Bleeding Amount (µm) |
|---|---|---|
| Example 31 | 1.0 | 29.9 |
| Example 32 | 2.0 | 48.4 |
| Example 33 | 3.0 | 43.9 |
| Example 34 | 4.0 | 115.9 |

As described in Table 3, it was confirmed that the adhesive layer containing the ethylene-unsaturated carboxylic acid copolymer or the metal salt thereof was excellent in adhesion to the copper foil, as compared to the adhesive layer containing other resins (the base material was a PET film).

From the above results, it was confirmed that, when the amount of the structural unit derived from an unsaturated carboxylic acid in the copolymer was not less than 3% by weight, adhesive strength to the copper foil was sufficient, and the amount was particularly preferably not less than 10% by weight. Furthermore, when the amount of an unsaturated carboxylic acid group in the copolymer exceeded 30% by weight, it was not preferable in terms of a balance among adhesive strength, heat resistance and molding processability. However, when it was not more than 30% by weight and particularly not more than 20% by weight, excellent balance was resulted. Accordingly, from the viewpoint of a balance among adhesive strength, heat resistance and molding processability, it was not more than 30% by weight and particularly preferably not more than 20% by weight.

Meanwhile, it was found that the protective film for an electronic component of the present invention came to have resistance to various chemicals used in a step of manufacturing an electronic component. Even when the protective film for an electronic component was, for example, used for a coverlay, the bleeding amount from the adhesive layer in the hole portion was also small and was practically satisfactory.
Accordingly, it is suggested that the protective film for an electronic component of the present invention is used for a circuit board such as a flexible printed board, a rigid printed board, a semiconductor device or an IC tag, adhesion between the adhesive layer and the metal foil or the like is excellent. So, the protective film for an electronic component of the present invention can be suitably used for a protective film for an electronic component thereof, a coverlay film or the like.

Furthermore, the present invention comprises the following configurations.
(a) A protective film for an electronic component, comprising a base material containing a heat resistant resin, and an adhesive layer formed on said base material and containing an ethylene-unsaturated carboxylic acid copolymer or a metal salt thereof.

(b) The protective film for an electronic component as set forth in (a), wherein, in the ethylene-unsaturated carboxylic acid copolymer or the metal salt thereof, the ethylene-unsaturated carboxylic acid copolymer is an ethylene-(meth)acrylic acid copolymer.

(c) The protective film for an electronic component as set forth in (a) or (b), wherein, in the ethylene-unsaturated carboxylic acid copolymer or the metal salt thereof, a metal cation constituting the metal salt is one or more kinds selected from the group consisting of Na⁺, K⁺, Li⁺, Ca²⁺, Mg²⁺, Zn²⁺, Cu²⁺, Co²⁺, Ni²⁺, Mn²⁺ and Al³⁺.

(d) The protective film for an electronic component as set forth in any one of (a) to (c), wherein said adhesive layer is obtained by extrusion molding the ethylene-unsaturated carboxylic acid copolymer or the metal salt thereof from a T die.

(e) The protective film for an electronic component as set forth in any one of (a) to (d), wherein MFR of the ethylene-unsaturated carboxylic acid copolymer or the metal salt thereof is 0.1 to 100 g/10 minutes.

(f) The protective film for an electronic component as set forth in any one of (a) to (e), wherein the ethylene-unsaturated carboxylic acid copolymer or the metal salt thereof contains 1 to 30% by weight of the structural unit derived from an unsaturated carboxylic acid.

(g) The protective film for an electronic component as set forth in any one of (a) to (f), wherein a layer containing an anchor coating agent is provided between said base material and said adhesive layer.

(h) The protective film for an electronic component as set forth in any one of (a) to (g), obtained by extruding the heated ethylene-unsaturated carboxylic acid copolymer or the metal salt thereof from a T die to give a film, and laminating the film on the base material.

(i) A method for manufacturing a protective film for an electronic component, comprising heating the ethylene-unsaturated carboxylic acid copolymer or the metal salt thereof, and forming an adhesive layer containing the ethylene-unsaturated carboxylic acid copolymer or the metal salt thereof on said base material to which a film formed by extruding the melted ethylene-unsaturated carboxylic acid copolymer or the metal salt thereof from a T die is laminated.

(j) The method for manufacturing a protective film for an electronic component as set forth in (i), further comprising:
applying an anchor coating agent on a surface of said base material to place said anchor coating agent in between said base material and said adhesive layer, before said the step of forming said adhesive layer.

(k) The method for manufacturing a protective film for an electronic component as set forth in (i) or (j), in which MFR of the ethylene-unsaturated carboxylic acid copolymer or the metal salt thereof is 0.1 to 100 g/10 minutes.

(1) The method for manufacturing a protective film for an electronic component as set forth in any one of (i) to (k), in which the ethylene-unsaturated carboxylic acid copolymer or the metal salt thereof contains 1 to 30% by weight of the structural unit derived from an unsaturated carboxylic acid.

(m) A circuit board comprising the protective film for an electronic component as set forth in any one of (a) to (h).
(n) The circuit board as set forth in (m), wherein the circuit board is a flexible printed circuit board.

(o) A semiconductor device comprising a substrate, a semiconductor element mounted on said substrate and the protective film for an electronic component as set forth in any one of (a) to (h) to cover said semiconductor element.
(p) An IC tag comprising a base material having an antenna, an IC chip mounted on said base material and the protective film for an electronic component as set forth in any one of (a) to (h) to cover said antenna and said IC chip.

## Claims

1. A protective film for an electronic component, comprising a base material containing a heat resistant resin, and
an adhesive layer formed on said base material and containing an ethylene-unsaturated carboxylic acid copolymer or a metal salt thereof,
wherein the ethylene-unsaturated carboxylic acid copolymer or the metal salt thereof contains 3 to 30% by weight of the structural unit derived from an unsaturated carboxylic acid.

2. The protective film for an electronic component as set forth in claim 1, wherein, in the ethylene-unsaturated carboxylic acid copolymer or the metal salt thereof, the ethylene-unsaturated carboxylic acid copolymer is an ethylene-(meth)acrylic acid copolymer.

3. The protective film for an electronic component as set forth in claim 1 or 2, wherein, in the ethylene-unsaturated carboxylic acid copolymer or the metal salt thereof, a metal cation constituting the metal salt is one or more kinds selected from the group consisting of Na⁺, K⁺, Li⁺, Ca²⁺, Mg²⁺, Zn²⁺, Cu²⁺, Co²⁺, Ni²⁺, Mn²⁺ and Al³⁺.

4. The protective film for an electronic component as set forth in any one of claims 1 to 3, wherein said adhesive layer is obtained by extrusion molding the ethylene-unsaturated carboxylic acid copolymer or the metal salt thereof from a T die.

5. The protective film for an electronic component as set forth in any one of claims 1 to 4, wherein MFR of the ethylene-unsaturated carboxylic acid copolymer or the metal salt thereof is 0.1 to 100 g/10 minutes.

6. The protective film for an electronic component as set forth in any one of claims 1 to 5, wherein a layer containing an anchor coating agent is provided between said base material and said adhesive layer.

7. The protective film for an electronic component as set forth in any one of claims 1 to 6, obtained by extruding the heated ethylene-unsaturated carboxylic acid copolymer or the metal salt thereof from a T die to give a film, and laminating the film on said base material.

8. A method for manufacturing a protective film for an electronic component, comprising:
heating the ethylene-unsaturated carboxylic acid copolymer or the metal salt thereof containing 3 to 30% by weight of the structural unit derived from an unsaturated carboxylic acid, and
forming an adhesive layer containing the ethylene-unsaturated carboxylic acid copolymer or the metal salt thereof on said base material to which a film formed by extruding the melted ethylene-unsaturated carboxylic acid copolymer or the metal salt thereof from a T die is laminated.

9. The method for manufacturing a protective film for an electronic component as set forth in claim 8, further comprising:
applying an anchor coating agent on a surface of said base material to place said anchor coating agent in between said base material and said adhesive layer, before said the step of forming said adhesive layer.

10. The method for manufacturing a protective film for an electronic component as set forth in claim 8 or 9, in which MFR of the ethylene-unsaturated carboxylic acid copolymer or the metal salt thereof is 0.1 to 100 g/10 minutes.

11. A circuit board obtained by bonding the protective film for an electronic component as set forth in any one of claims 1 to 7 thereto.

12. The circuit board as set forth in claim 11, wherein the circuit board is a flexible printed circuit board.

13. A semiconductor device comprising:
a substrate,
a semiconductor element mounted on said substrate and
the protective film for an electronic component as set forth in any one of claims 1 to 7 bonded to the surface of said semiconductor element.

14. An IC tag comprising:
a base material having an antenna,
an IC chip mounted on said base material and
the protective film for an electronic component as set forth in any one of claims 1 to 7 bonded to the surfaces of said antenna and said IC chip.
